# EUROPEAN PATENT APPLICATION

(11) **EP 2 466 655 A1**
(43) Date of publication of application: **20.06.2012**
(21) Application number: 10194987.3
(22) Date of filing: 14.12.2010
(51) Int. Cl.: H01L 33/44, H01L 33/58

(54) **LED package structure and manufacturing method for the same**

(71) Applicant: Liang Meng Plastic Share Co. Ltd., Shulin City, Taipei County 238 (TW)
(72) Inventor: LAI, Kuang-Chu, Shulin City, Taipei County 238 (TW)
(74) Representative: 2K Patentanwälte Blasberg Kewitz & Reichel

(57) **Abstract**

The LED package structure of the invention includes a substrate (1), an LED chip (2) mounted on the substrate (1) and a lens (3) covering the LED chip (2). A light penetrable film (4) whose refractive index is between those of the lens (3) and LED chip (2) is formed between the LED chip (2) and lens (3). The light penetrable film (4) is formed on the inner surface of the lens (3) facing the LED chip (2) in advance. The lens (3) is applied with hot pressing while the lens (3) is packaged so as to make the light penetrable film (4) coated on the LED chip (2).

## Description

### Background of the Invention

### 1. Technical Field

The invention relates to light emitting diodes (LEDs), particularly to the packaging of the LEDs.

### 2. Related Art

LEDs have been extensively applied in various lighting circumstances. A lens must be packaged on the LED chip. However, the refractive index of conventional LED chips (about from 2.45 to 3.4) is always higher than that of the package material or lens (usually made of plastic having refractive index of 1.4∼1.5). Because of the large difference of these two refractive indexes, the rate of the total internal reflection happening when a ray of light passes through the package material or lens also becomes large. As a result, the effective luminous flux will be reduced. To achieve an expected lumen value, LED chips must be provided with higher power to compensate the optical loss. This is a needless waste of cost.

### SUMMARY OF THE INVENTION

A primary object of the invention is to provide an LED package structure which can increase the light extraction efficiency of LED devices. That is to say, the loss of the light energy from the LED chips can be efficiently reduced.

A secondary object of the invention is to provide a method for manufacture an LED package structure which disposes a light penetrable film between an LED chip and a lens.

To accomplish the above primary object, the LED package structure of the invention includes a substrate, an LED chip mounted on the substrate and a lens covering the LED chip. A light penetrable film whose refractive index is between those of the lens and LED chip is formed between the LED chip and lens.

To accomplish the above secondary object, the method for manufacturing the LED package structure of the invention includes the steps of:
a) providing a substrate with an LED chip and a light penetrable cap for being packaged on the LED chip;
b) forming a light penetrable film on an inner surface of the light penetrable cap (30) facing the LED chip, wherein a refractive index of the light penetrable film (4) is between those of the light penetrable cap (30) and the LED chip (2);
c) putting the light penetrating cap on the LED chip and applying hot pressing to the light penetrable cap while the LED chip is being packaged so as to make the light penetrable film coated on the LED chip.

### BRIRF DESCRIPTION OF THE INVENTION

FIG. 1 is a flowchart of the manufacturing method of the invention;
FIG. 2 is a top plan view of the substrate of the invention;
FIG. 3 is a schematic view showing the process of assembling the substrate and light penetrable cap;
FIG. 4 is a cross-sectional view of the invention;
FIG. 5 is a cross-sectional view of the invention with the package layer; and
FIG. 6 is a cross-sectional view of another embodiment of the invention.

### DETAILED DESCRIPTION OF THE INVENTION

The invention provides an LED package structure and a manufacture method for the same. The invention adds at least one light penetrable film, whose refractive index is between the LED chip and the lens, in the lens of the LED chip. Thereby the light extraction efficiency can be increased.

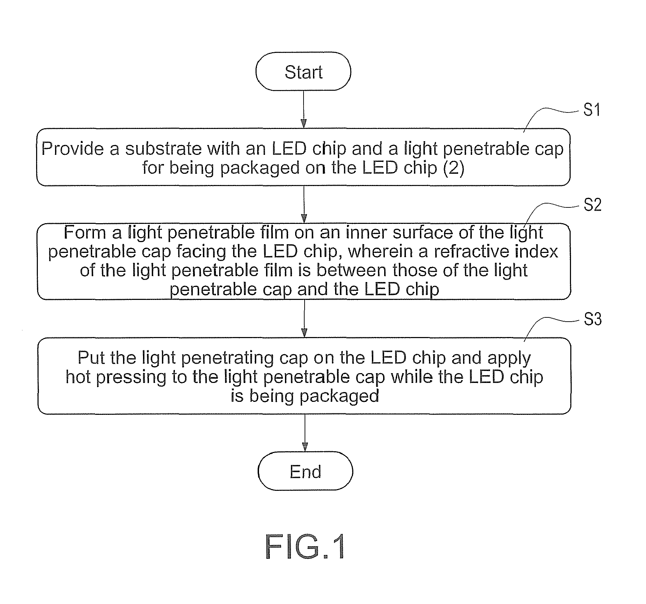

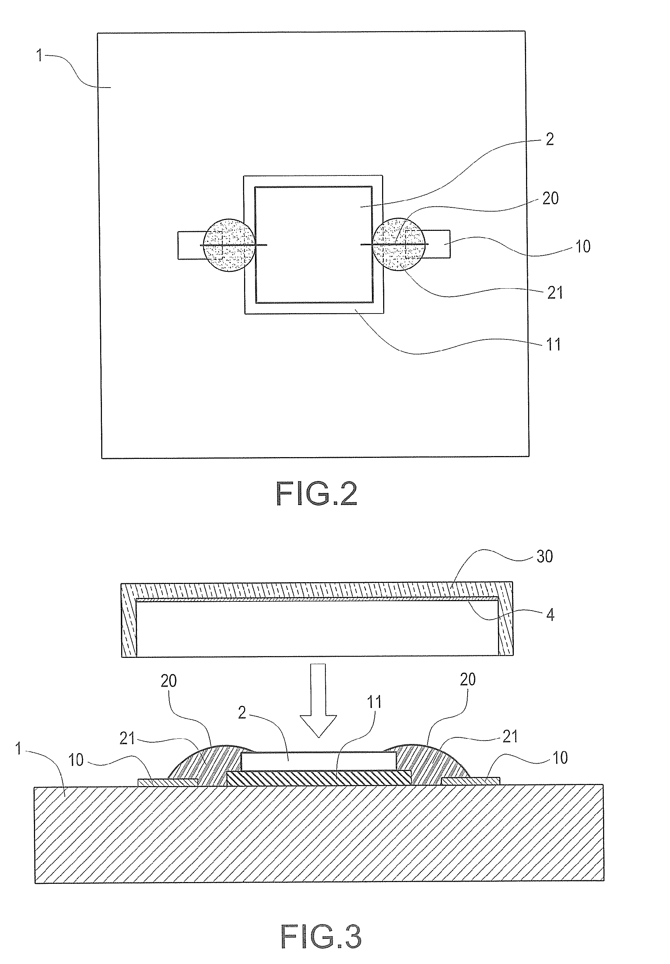

FIG. 1 is a flowchart of the method of the invention. Please refer to FIGs. 1-3. In step S1, a substrate 1 with an LED chip 2 and a light penetrable cap 30 for being packaged on the LED chip 2 are provided. As shown in FIG. 2, the substrate 1 with LED chip 2 is provided with two conductive layers 10 as a positive electrode and a negative electrode. The LED chip 2 is located between the two conductive layers 10 and is separately electrically connected to the two conductive layers 10 by two wires 20. The wires 20 are applied with an adhesive 21 such as silicone for fixation to prevent the wires 20 from being broken. Additionally, silver epoxy may be applied between the LED chip 2 and the substrate 1.

Please refer to FIGs. 1 and 3. In step S2, a light penetrable film 4 is formed on the inner surface of the light penetrable cap 30 facing the LED chip 2, in which the refractive index of the light penetrable film 4 (n) is between those of the light penetrable cap 30 (n_{cap}) and the LED chip 2 (n_{chip}), i.e. the refractive index of the LED chip 2 (n_{chip})>the refractive index of the light penetrable film (n)>the refractive index of the light penetrable cap (n_{cap}). For example, if the refractive index of the LED chip 2 (n_{chip}) is between 2.45 and 3.4 and that of the light penetrable cap 30 (n_{cap}) is between 1.4 and 1.5, then that of the light penetrable film 4 (n) is just between 1.4 and 3.4. Thus the light penetrable film 4 may be made of titanium dioxide (Ti0₂), silicon dioxide (Si0₂) or aluminum oxide (Al₂0₃) and may be formed on the light penetrable cap 30 by the deposition technique, especially the ion beam assisted deposition.

Please refer to FIGs. 1, 4 and 5. In step S3, the light penetrable cap 30 is put on the LED chip 2 and the light penetrable cap 30 is applied with hot pressing while the LED chip 2 is being packaged so as to make the light penetrable film 4 coated on the LED chip 2. A package layer 31 is formed on the light penetrable cap 30 by the in-mold decoration (IMD) technique. The package layer 31 and the light penetrable cap 30 will be fused together during the hot pressing because they are made of the same material. As a result, the light penetrable cap 30 and package layer 31 constitute a lens 3.

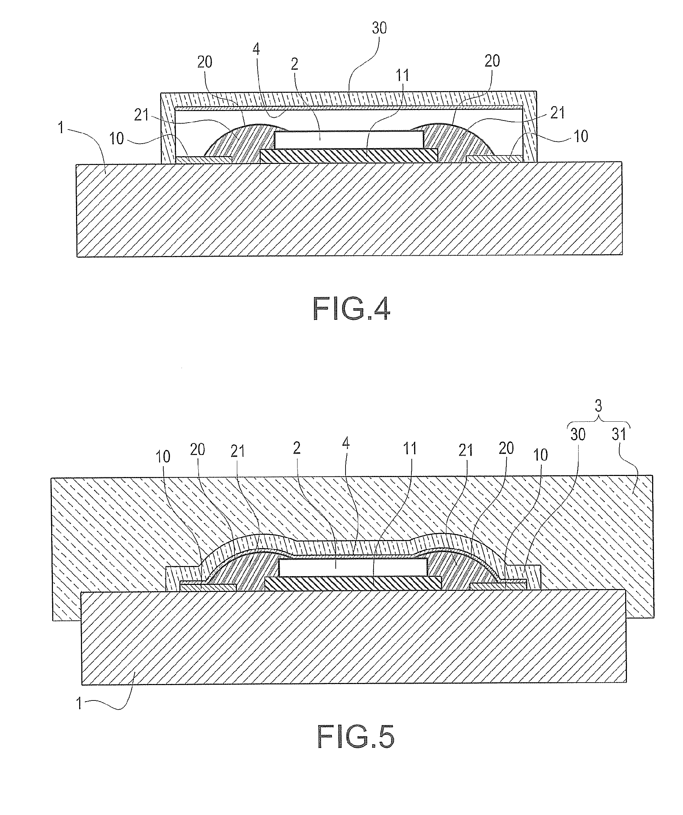

As can be seen in FIG. 5, the LED package structure of the invention includes the substrate 1, the LED chip 2 mounted on the substrate 1 and the lens 3 packaged on the LED chip 2. The light penetrable film 4 is formed between the LED chip 2 and the lens 3.And the refractive index of the light penetrable film 4 (n) is between those of the lens 3 and the LED chip 2, i.e. the refractive index of the LED chip 2 (n_{chip})>the refractive index of the light penetrable film (n)>the refractive index of the lens (nₗₑₙₛ).

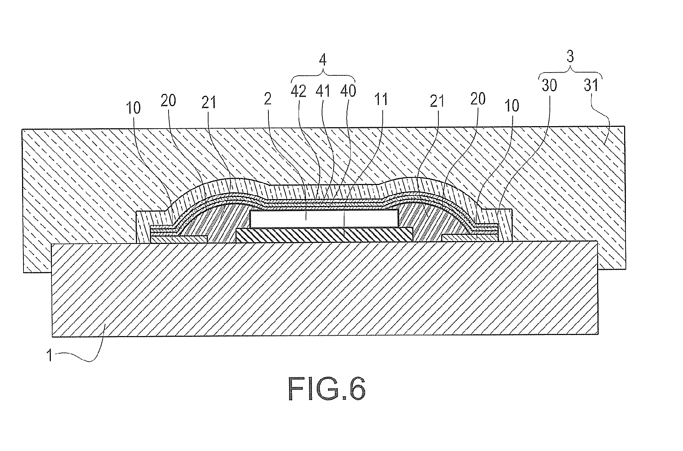

As shown in FIG. 6, the light penetrable film 4 may be composed of plural overlapping sublayers with different refractive indexes. In the embodiment shown in FIG. 6, the light penetrable film 4 is composed of a first sublayer 40, a second sublayer 41 and a third sublayer 42. And the refractive indexes of these three sublayers 40, 41, 42 are arranged in a decreasing order corresponding to those of the LED chip 2 and the lens 3 (or the light penetrable cap 30). For example, the refractive indexes of the first, second and third sublayer 40, 41, 42 may be 2.2, 1.95 and 1.7, respectively. This can further reduce the total internal reflection when the light is passing through the lens 3. In other words, the light extraction efficiency is improved.

## Claims

1. A light emitting diode (LED) package structure comprising:
a substrate (1);
an LED chip (2) mounted on the substrate (1); and
a lens (3) packaged on the LED chip (2);
wherein a light penetrable film (4) is formed between the LED chip (2) and the lens (3), the light penetrable film (4) is on an inner surface of the lens (3) facing the LED chip (2), and a refractive index of the light penetrable film (4) is between those of the lens (3) and the LED chip (2).

2. The LED package structure of claim 1, wherein the substrate (1) is provided with two conductive layers (10), the LED chip (2) is located between the two conductive layers (10) and is separately electrically connected to the two conductive layers (10) by two wires (20).

3. The LED package structure of claim 2, wherein the two wires (20) are applied with an adhesive (21).

4. The LED package structure of any of the preceding claims, wherein a silver epoxy (11) is applied between the LED chip (2) and the substrate (1).

5. The LED package structure of any of the preceding claims, wherein the lens (3) comprises a light penetrable cap (30) and a package layer (31).

6. The LED package structure of any of the preceding claims, wherein the light penetrable film (4) is made of titanium dioxide (Ti0₂), silicon dioxide (Si0₂) or aluminum oxide (Al₂0₃).

7. The LED package structure of any of the preceding claims, wherein the light penetrable film (4) is composed of plural overlapping sublayers (40, 41, 42) with different refractive indexes, and refractive indexes of the three sublayers (40, 41, 42) are arranged in a decreasing order corresponding to those of the LED chip (2) and the lens (3).

8. A method for manufacturing a light emitting diode (LED) package, in particular according to any of the preceding claims, comprising the steps of:
a) providing a substrate (1) with an LED chip (2) and a light penetrable cap (30) for being packaged on the LED chip (2);
b) forming a light penetrable film (4) on an inner surface of the light penetrable cap (30) facing the LED chip (2), wherein a refractive index of the light penetrable film (4) is between those of the light penetrable cap (30) and the LED chip (2);
c) putting the light penetrating cap (30) on the LED chip (2) and applying hot pressing to the light penetrable cap (30) while the LED chip (2) is being packaged so as to make the light penetrable film (4) coated on the LED chip (2).

9. The method of claim 8, wherein the light penetrable film (4) is made of titanium dioxide (Ti0₂), silicon dioxide (Si0₂) or aluminum oxide (Al₂0₃).

10. The method of claim 8 or 9, wherein the step b) is performed by a deposition process.

11. The method of any claims 8 to 10, wherein the deposition process is an ion beam assisted deposition process.

12. The method of any claims 8 to 11, wherein the light penetrable film (4) of the step b) is composed of plural overlapping sublayers (40, 41, 42) with different refractive indexes, and refractive indexes of the three sublayers (40, 41, 42) are arranged in a decreasing order corresponding to those of the LED chip (2) and the lens (3).
